# EUROPEAN PATENT APPLICATION

(11) **EP 4 783 760 A1**
(43) Date of publication of application: **29.07.2026**
(21) Application number: 24868689.1
(22) Date of filing: 20.09.2024
(51) Int. Cl.: H05K 7/20, F28D 15/02, F28F 21/08

(54) **HEAT DISSIPATION APPARATUS**

(30) Priority: 20.09.2023 KR 20230125689; 25.10.2023 KR 20230143438; 19.09.2024 KR 20240126698
(71) Applicant: KMW Inc., Hwaseong-si, Gyeonggi-do 18462 (KR)
(72) Inventor: LEE, Keum Hwan, Busan 49459 (KR); JI, Kyo Sung, Hwaseong-si Gyeonggi-do 18484 (KR); SEO, Jin Kook, Busan 46726 (KR); RYU, Chi Back, Hwaseong-si Gyeonggi-do 18378 (KR); CHOI, Kyu Chul, Osan-si Gyeonggi-do 18151 (KR); KIM, Dong Won, Bucheon-si Gyeonggi-do 14574 (KR); KANG, Hyun Gyu, Osan-si Gyeonggi-do 18114 (KR); CHOI, In Hwa, Yongin-si Gyeonggi-do 17148 (KR)
(74) Representative: impuls legal PartG mbB
(86) International application number: PCT/KR2024/014138
(87) International publication number: WO 2025/063712

(57) **Abstract**

A heat dissipation apparatus according to the present invention comprises: a one-side heat-conducting panel provided as a metal panel member; an other-side heat-conducting panel forming the refrigerant flow space in which a refrigerant is phase-changed and flows between the one-side heat-conducting panel and the other-side heat-conducting panel, and being provided as a metal panel member; and a bonding medium frame body for mediating the bonding of edge ends of the one-side heat-conducting panel and the other-side heat-conducting panel, and thus the present invention maximizes heat dissipation performance and greatly enhances product productivity.

## Description

### [Technical Field]

The present disclosure relates to a heat dissipation apparatus, and more particularly, to a heat dissipation apparatus, which is designed to prevent a change in the volume of a refrigerant flow space despite a change in internal pressure within the refrigerant flow space during a phase change of a refrigerant, which is a phase change material, and to enable a condensed liquid refrigerant to be uniformly collected in a direction of gravity, thereby maximizing heat dissipation performance, and which forms a sharp edge portion to be rounded, thereby preventing injury to a worker, and also improving product productivity.

### [Background Art]

In various industrial fields such as communications, electronics, and electricity, related technologies are continuously being developed to a high level for application to more advanced industries. In order to develop highly advanced technologies, high-output energy is required, and devices that use high-output energy inevitably face the problem of high heat generation. Thus, the development of a cooling system at an appropriate level should be accompanied therewith.

The cooling system is used in various industries, including air conditioners, mobile communications, data centers, air mobility, electric vehicles, energy storage devices, and displays. Such a cooling system is one of the major causes of power consumption, and the power consumption is gradually increasing as industries continue to develop.

In general, a cooling device may be broadly classified into an active cooling device and a passive cooling device. The active cooling device mainly utilizes forced convection generated by a fan, whereas the passive cooling device may be classified as a technology that utilizes natural convection without using a fan.

However, a conventional cooling system has limitations in dissipating a high level of heat generated by continuously developing and advanced technologies. Thus, there is a need in related industrial fields for innovative technologies capable of solving these problems, and as part of efforts to solve them, heat dissipation apparatuses are being developed.

A phase change refers to a change in the inherent state of liquid, gas, or solid when it accumulates a large amount of energy or releases stored thermal energy.

The phase change refers to a change in the physical arrangement of molecules rather than a chemical reaction such as chemical bonding or formation. The heat in a state in which no phase change occurs when energy is applied to a substance is referred to as sensible heat, whereas the heat used during a phase change is referred to as latent heat.

However, the heat dissipation apparatus has a problem in that pressure increases as temperature rises, because temperature and pressure are proportional to each other. When pressure increases due to high temperature conducted from a heating element within the sealed heat dissipation apparatus, it may cause the heat dissipation apparatus itself to rupture. To address this problem, it is necessary to prevent the pressure from increasing, and the heat dissipation apparatus requires a sufficient internal volume to allow pressure equilibrium to be achieved during the phase-change circulation process of a substance.

### [Disclosure]

### [Technical Problem]

The present disclosure is proposed to resolve the aforementioned technical issues and is directed to providing a heat dissipation apparatus that can maximize heat dissipation performance.

In addition, the present disclosure is directed to providing a heat dissipation apparatus that can improve the productivity of a product.

Further, the present disclosure is directed to providing a heat dissipation apparatus that can prevent injury to an installation worker.

Technical issues of the present disclosure are not limited to the technical issues mentioned above, and other technical issues not mentioned above will be clearly understood by those skilled in the art from the following description.

### [Technical Solution]

A heat dissipation apparatus according to an embodiment of the present disclosure includes a first-side heat-conducting panel provided as a metal panel member, a second-side heat-conducting panel provided as a metal panel member and forming, together with the first-side heat-conducting panel, a refrigerant flow space in which a refrigerant undergoes a phase change and flows, and a bonding medium frame body provided to mediate bonding of edge portions of the first-side heat-conducting panel and the second-side heat-conducting panel.

The bonding medium frame body may be formed between the first-side heat-conducting panel and the second-side heat-conducting panel, and may seal the refrigerant flow space.

The first-side heat-conducting panel and the second-side heat-conducting panel may be made of the same metal material having a thermal conductivity equal to or greater than a predetermined level.

The bonding medium frame body may mediate surface-bonded stacked coupling along the edge portions of the first-side heat-conducting panel and the second-side heat-conducting panel.

The bonding medium frame body may be disposed between the first-side heat-conducting panel and the second-side heat-conducting panel to provide a predetermined bonding surface with respect to an inner surface of the edge portion of the first-side heat-conducting panel and an inner surface of the edge portion of the second-side heat-conducting panel.

The bonding medium frame body may have a rectangular pipe cross-section made of copper (Cu).

A first surface of the rectangular pipe cross-section of the bonding medium frame body may be surface-bonded to the inner surface of the edge portion of the first-side heat-conducting panel, and a second surface of the rectangular pipe cross-section of the bonding medium frame body, which faces the first surface, may be surface-bonded to the inner surface of the edge portion of the second-side heat-conducting panel.

When a portion of the refrigerant flow space which is relatively located on a lower side with respect to a direction of gravity, in which liquid refrigerant of the refrigerant is stored and which is relatively close to heat-generating elements supplying heat, is defined as an evaporator, the bonding medium frame body may include a first frame installed close to the evaporator and a second frame installed at a portion other than the evaporator, the first frame and the second frame being made of different materials.

The first frame may be formed to have a rectangular pipe cross-section made of copper (Cu), and the second frame may be formed to have a rectangular pipe cross-section made of SUS.

The heat dissipation apparatus may further include a plurality of condenser sintered columns disposed in the refrigerant flow space and connected to the bonding medium frame body.

The plurality of condenser sintered columns may be connected to the bonding medium frame body via an evaporator sintered base that connects respective one ends thereof.

The plurality of condenser sintered columns may be provided in a straight line, and a lower end corresponding to the one end may be positioned relatively lower than an upper end with respect to the direction of gravity.

One end of each of the plurality of condenser sintered columns may be connected to an inner side of the bonding medium frame body that is relatively positioned on a lower side with respect to the direction of gravity.

The other end of each of the plurality of condenser sintered columns may be connected to an inner side of the bonding medium frame body that is relatively positioned on an upper side with respect to the direction of gravity.

The other end of each of the plurality of condenser sintered columns may be spaced apart from the bonding medium frame body that is relatively positioned on the upper side with respect to the direction of gravity, by a predetermined distance.

The first-side heat-conducting panel and the second-side heat-conducting panel may be provided as metal panel members made of SUS.

The plurality of condenser sintered columns and the evaporator sintered base may be formed by sintering powder of SUS.

The bonding medium frame body may be formed with an air vent hole to which an air vent tube for vacuumizing the refrigerant flow space or filling the refrigerant is connected.

The air vent hole may be formed to communicate with the refrigerant flow space.

The first-side heat-conducting panel, the second-side heat-conducting panel, and the bonding medium frame body may be stacked and bonded by a laser welding method.

The first-side heat-conducting panel, the second-side heat-conducting panel, and the bonding medium frame body may be stacked and bonded by a brazing welding method.

Each of the plurality of condenser sintered columns may be formed with a plurality of support protrusions that protrude toward and are supported by an inner surface of the first-side heat-conducting panel or the second-side heat-conducting panel within the refrigerant flow space.

The plurality of support protrusions may include front end surfaces that contact the inner surface of the first-side heat-conducting panel or the second-side heat-conducting panel.

### [Advantageous Effects]

A heat dissipation apparatus according to an embodiment of the present disclosure can achieve various effects as follows.

First, the present disclosure has an effect of significantly improving overall heat dissipation performance by dissipating system heat through a process in which a refrigerant filled therein undergoes a phase change.

Second, the present disclosure has an effect of significantly improving the productivity of a product by easily forming a refrigerant flow space, in which a refrigerant is filled, by bonding two metal panel members through a laser welding process or a brazing welding process.

Third, the present disclosure has an effect of improving work safety by preventing injury to a worker through forming a sharp edge portion of a product to be rounded.

### [Description of Drawings]

FIG**.** 1 is a perspective view illustrating a heat dissipation apparatus according to embodiments of the present disclosure;
FIG. 2 is an exploded perspective view illustrating the heat dissipation apparatus according to embodiments of the present disclosure;
FIGS. 3A to 3D are individual exploded perspective views illustrating the heat dissipation apparatus according to embodiments of the present disclosure;
FIG. 4 is an exploded perspective view illustrating a modification of the embodiments of the present disclosure;
FIGS. 5A to 5D are perspective views illustrating a state in which a first-side heat-conducting panel and a second-side heat-conducting panel are removed from components of FIGS. 3A to 3D;
FIG. 6 is a perspective view illustrating various embodiments of a condenser sintered column and an evaporator sintered base among components of FIG. 2;
FIG. 7 is a perspective view illustrating a heat dissipation apparatus according to another embodiment of the present disclosure;
FIG. 8 is an exploded perspective view of FIG. 7; and
FIG. 9 is an exploded perspective view illustrating a modification of another embodiment of the present disclosure.

### <Description of reference numerals>

200: Heat dissipation apparatus 200A: First-side heat-conducting panel
200B: Second-side heat-conducting panel 201: Evaporator
203: Condenser 205: Refrigerant flow space
230: Strength reinforcement portion 235: Column support protrusion
250: Condenser sintered column 255: Evaporator Sintered Base
280: Bonding medium frame body 285: Air vent hole
290: Air vent tube

### [Mode for Invention]

Hereinafter, a heat dissipation apparatus according to an embodiment of the present disclosure will be described in detail with reference to the accompanying drawings.

It is to be noted that in assigning reference numerals to elements in the drawings, the same reference numerals denote the same elements as much as possible even in cases where the elements are shown in different drawings. Furthermore, in describing the embodiments of the present disclosure, a detailed description of the known configurations or functions will be omitted if it is deemed to obscure the understanding for the embodiments of the present disclosure.

In describing the elements of an embodiment of the present disclosure, terms, such as the first, the second, A, B, (a), and (b) may be used. However, the terms are used only to distinguish one element from the other element, and the essence, order, or sequence of the elements is not limited by the terms. Furthermore, unless otherwise defined, all terms used herein including technical or scientific terms have the same meanings as generally understood by those skilled in the art to which the present disclosure pertains. The terms, such as terms defined in dictionaries, which are generally used, should be construed as having meanings identical to contextual meanings of the related art, and are not construed as having ideal or excessively formal meanings unless they are definitely defined in the present disclosure.

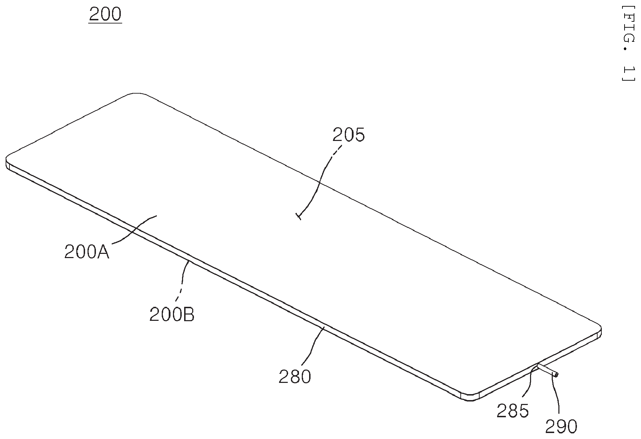

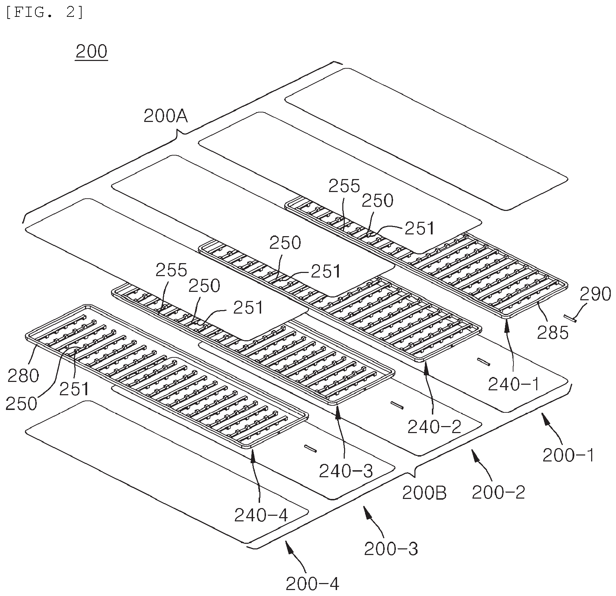

FIG. 1 is a perspective view illustrating a heat dissipation apparatus according to embodiments of the present disclosure, and FIG. 2 is an exploded perspective view illustrating the heat dissipation apparatus according to embodiments of the present disclosure.

As shown in FIGS. 1 and 2, a heat dissipation apparatus 200 according to an embodiment of the present disclosure includes a first-side heat-conducting panel 200A provided as a metal panel member, a second-side heat-conducting panel 200B provided as a metal panel member and forming, together with the first-side heat-conducting panel 200A, a refrigerant flow space 205 in which a refrigerant undergoes a phase change and flows, and a bonding medium frame body 280 configured to mediate bonding of edge portions of the first-side heat-conducting panel 200A and the second-side heat-conducting panel 200B.

Here, the first-side heat-conducting panel 200A and the second-side heat-conducting panel 200B may be made of the same metal material (metal panel material) having a thermal conductivity equal to or greater than a predetermined level.

Preferably, the panels may be made of at least stainless steel (SUS) among metal materials so that phase change of the refrigerant through heat exchange with outside air (outdoor air), particularly a phase change in which the refrigerant condenses from a vapor phase into a liquid phase, may be smoothly performed.

The specific reason for adopting the SUS material as the metal material forming the first-side heat-conducting panel 200A and the second-side heat-conducting panel 200B will be described in more detail later.

In addition, in the heat dissipation apparatus 200 according to an embodiment of the present disclosure, the first-side heat-conducting panel 200A and the second-side heat-conducting panel 200B may be formed by sheet metal processing using a press forming process.

For reference, although the press forming process is not shown, it may be understood as a process in which a metal base panel made of SUS is subjected to the sheet metal processing through a press forming device so that at least respective edge portions are bonded to each other by the bonding medium frame body 280. At this time, a plurality of strength reinforcement portions 230 of a heat dissipation apparatus 200-5 according to another embodiment of the present disclosure, which will be described later, may be simultaneously formed.

That is, the first-side heat-conducting panel 200A and the second-side heat-conducting panel 200B may be sheet metal processed products of a metal panel member made of SUS. The thicknesses of the first-side heat-conducting panel 200A and the second-side heat-conducting panel 200B are set to be very thin, and may be set to a thickness not exceeding 0.15 t.

In general, among metal materials, aluminum (Al) is well known as the most widely used material in terms of thermal conductivity and weight. Here, when a heat dissipation device itself, which substantially performs a heat dissipation or heat exchange function, has the form of heat sink fins and performs heat transfer solely through the material itself without using a phase-changeable refrigerant as a heat transfer medium as in an embodiment of the present disclosure, it is natural that aluminum be adopted as an optimal material.

That is, since aluminum has a very excellent thermal conductivity of 230 and has a low specific gravity, it is one of the most widely adopted materials as a heat dissipation element.

However, although aluminum has thermal conductivity and specific gravity superior to those of SUS, which is the material of the first-side heat-conducting panel 200A and second-side heat-conducting panel 200B adopted in an embodiment of the present disclosure (in fact, the thermal conductivity of SUS is 20), aluminum is relatively expensive in terms of cost, and when a refrigerant is filled therein, the type of refrigerant that may be filled is very limited.

For example, when distilled water (water) is adopted as the refrigerant, a chemical reaction occurs in the case of aluminum, making it impossible for the distilled water to function as the refrigerant, and thus there has been a problem in that distilled water should be excluded from the selectable refrigerant.

In order to solve the problems of aluminum, in the heat dissipation device 200 according to an embodiment of the present disclosure, the metal material of the first-side heat-conducting panel 200A and second-side heat-conducting panel 200B uses SUS that hardly causes a chemical reaction with distilled water.

The first-side heat-conducting panel 200A and the second-side heat-conducting panel 200B may be stacked and bonded to each other along their edge portions via the bonding medium frame body 280.

More specifically, as shown in FIGS. 1 and 2, the bonding medium frame body 280 is disposed to mediate surface-bonded stacked coupling along the edge portions of the first-side heat-conducting panel 200A and second-side heat-conducting panel 200B. The bonding medium frame body is disposed between the first-side heat-conducting panel 200A and the second-side heat-conducting panel 200B and may serve to provide a predetermined bonding surface with respect to an inner surface of the edge portion of the first-side heat-conducting panel 200A and an inner surface of the edge portion of the second-side heat-conducting panel 200B.

Here, the bonding medium frame body 280 may be formed to have a rectangular pipe cross-section made of Cu. More specifically, the bonding medium frame body 280 may be formed by bending a metal plate made of Cu to have a rectangular cross-section.

The bonding medium frame body 280, which is formed in a straight shape to have the rectangular cross-section as described above, may be bent to correspond to the edge shapes of the first-side heat-conducting panel 200A and second-side heat-conducting panel 200B by using a bending apparatus (not shown).

In addition, the bonding medium frame body 280 also serves to seal the refrigerant flow space 205 defined between the first-side heat-conducting panel 200A and the second-side heat-conducting panel 200B, as described above.

More specifically, among the four cross-sections of the bonding medium frame body 280, an upper surface and a lower surface corresponding to cross-sections facing each other are stacked so as to respectively contact a lower surface corresponding to the edge portion of the first-side heat-conducting panel 200A disposed above in the drawing and an upper surface corresponding to the edge portion of the second-side heat-conducting panel 200B disposed below in the drawing, and are surface-bonded and stacked through the stacked surfaces.

For example, a first surface (reference numeral not shown) in the rectangular pipe cross-section of the bonding medium frame body 280 may be surface-bonded to the inner surface of the edge portion of the first-side heat-conducting panel 200A, while a second surface (a surface facing the first surface) in the rectangular pipe cross-section of the bonding medium frame body 280 may be surface-bonded to the inner surface of the edge portion of the second-side heat-conducting panel 200B.

Here, a surface-bonded portion between the upper surface of the bonding medium frame body 280 and the first-side heat-conducting panel 200A, and a surface-bonded portion between the lower surface of the bonding medium frame body 280 and the second-side heat-conducting panel 200B may be bonded by a welding coupling method.

In this case, the welding coupling method may include either a coupling method using a brazing welding process or a coupling method using a laser welding process.

However, the welding coupling method is not necessarily limited to only one of the brazing welding process and the laser welding process.

For example, for bonding inside the refrigerant flow space 205, such as a plurality of strength reinforcement portions 230 described later, the brazing welding process is a more suitable coupling method. In contrast, for bonding the edge portions of the first-side heat-conducting panel 200A and the second-side heat-conducting panel 200B, the laser welding process is more suitable. Accordingly, the two processes may be used in combination.

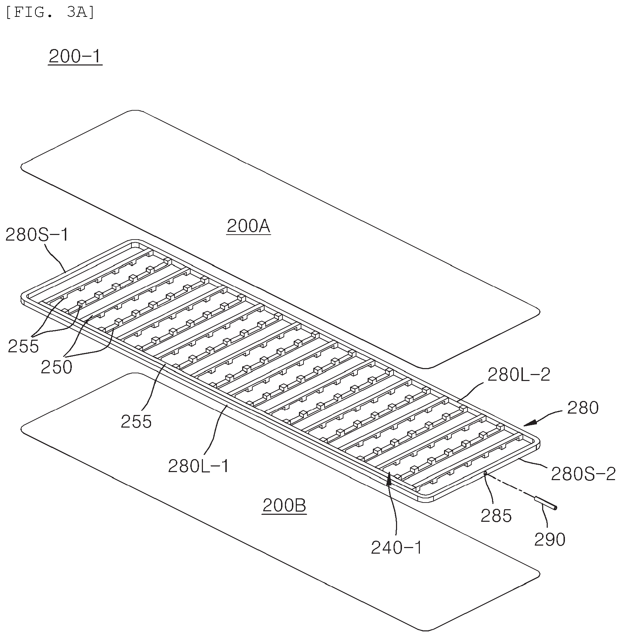

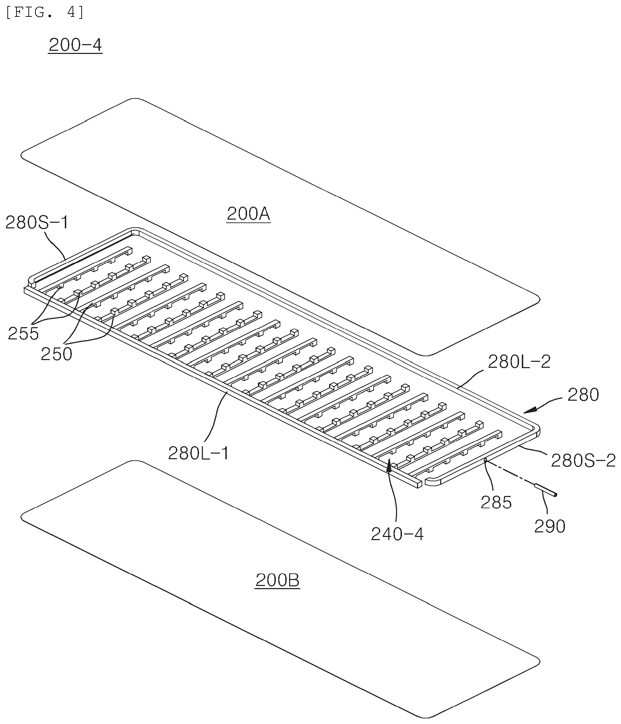

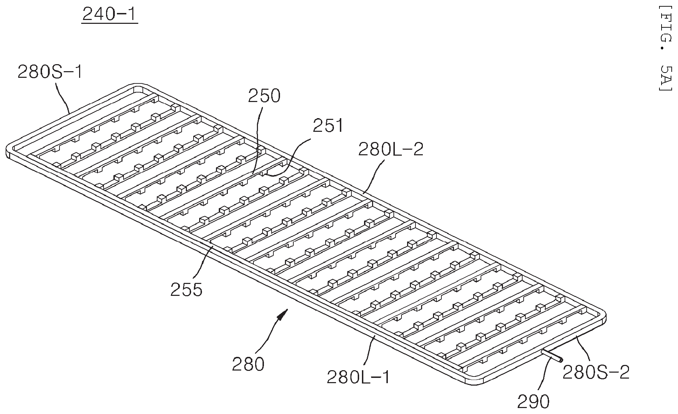

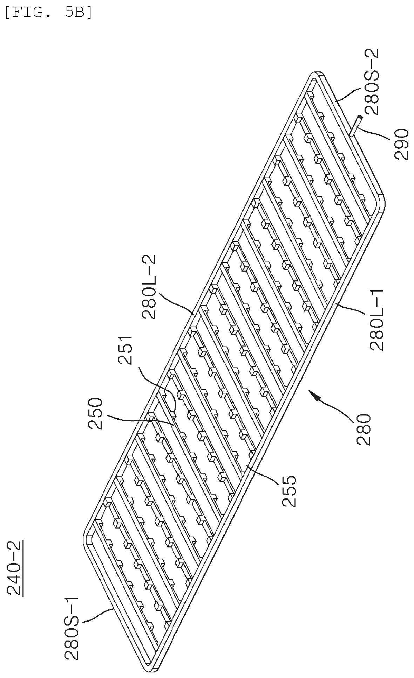

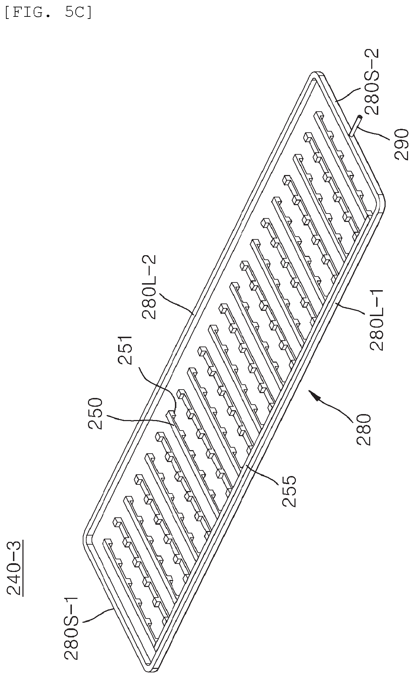

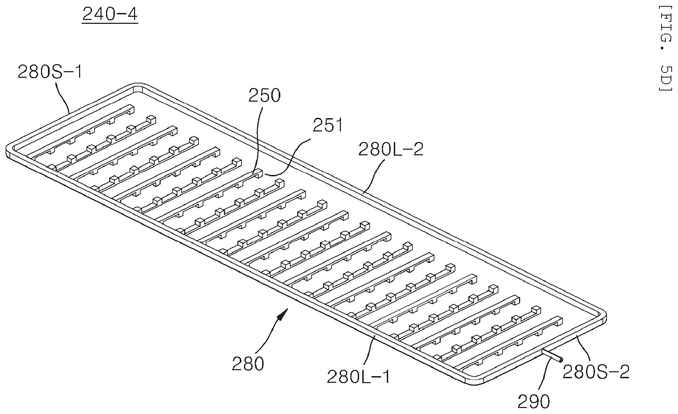

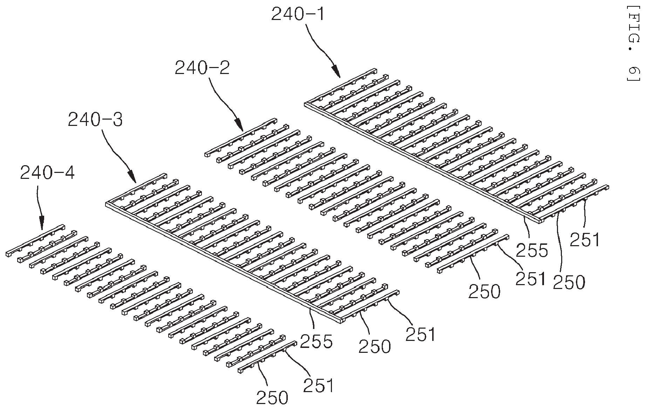

FIGS. 3A to 3D are individual exploded perspective views illustrating the heat dissipation apparatus according to embodiments of the present disclosure, FIG. 4 is an exploded perspective view illustrating a modification of the embodiments of the present disclosure, FIGS. 5A to 5D are perspective views illustrating a state in which the first-side heat-conducting panel and the second-side heat-conducting panel are removed from components of FIGS. 3A to 3D, and FIG. 6 is a perspective view illustrating various embodiments of a condenser sintered column and an evaporator sintered base among components of FIG. 2.

The heat dissipation apparatus 200 according to an embodiment of the present disclosure may further include a plurality of condenser sintered columns 250 disposed in the refrigerant flow space 205 and connected to the bonding medium frame body 280, as shown in FIGS. 3A to 6.

Here, the plurality of condenser sintered columns 250 and an evaporator sintered base 255 to be described later may be formed by sintering SUS powder. Hereinafter, since the plurality of condenser sintered columns 250 and the evaporator sintered base 255 to be described later differ only in characteristics (functions) contributing to the phase change of the refrigerant according to installation positions within the refrigerant flow space 205, their manufacturing method will be described on the assumption that they are the same.

Further, in the heat dissipation apparatus 200 according to an embodiment of the present disclosure, the bonding medium frame body 280 will be described on the assumption that it is provided in a substantially rectangular (quadrangular) shape, as shown in FIGS. 3A to 3D.

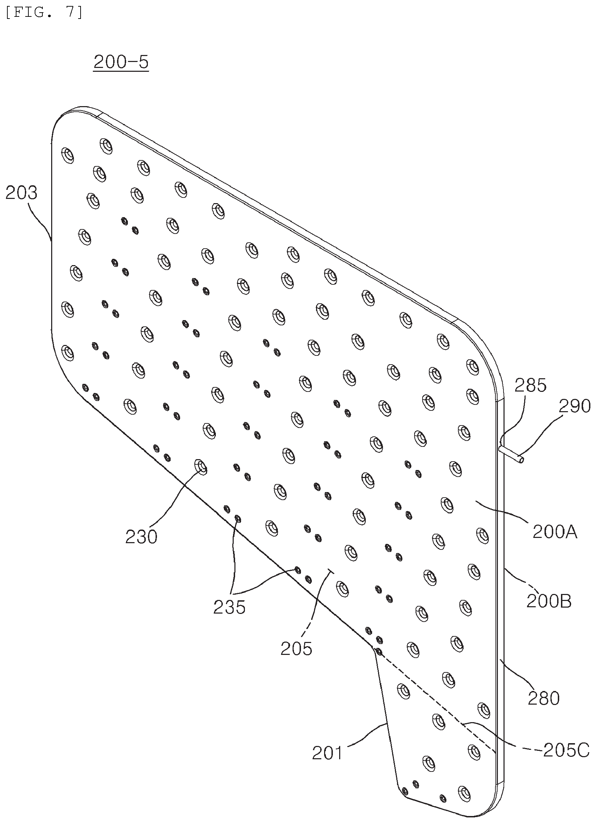

However, the bonding medium frame body 280 is not necessarily limited to being formed in a rectangular shape identical to the outer shapes of the first-side heat-conducting panel 200A and second-side heat-conducting panel 200B as shown in FIGS. 1 to 6, and may also be formed in different shapes for each product, as shown in FIGS. 7 to 9 to be described later.

For example, as shown in FIGS. 3A to 3D, the heat dissipation apparatus 200 according to an embodiment of the present disclosure is illustrated as having a rectangular shape in which both the width and the length are the same. However, the width and the length may be manufactured differently to be suitable for the shape and layout design of an actual electronic apparatus (electronic device) requiring system heat dissipation.

In addition, as in the heat dissipation apparatus 200 according to another embodiment of the present disclosure to be described later, a design may be modified such that a condenser 203 extends to have an area larger than that of an evaporator 201 so as to perform system heat dissipation at a location farther from the installation area of the actual electronic apparatus (electronic device).

However, in the heat dissipation apparatus 200 according to an embodiment of the present disclosure, for convenience of understanding, the first-side heat-conducting panel 200A, the second-side heat-conducting panel 200B, and the bonding medium frame body 280 correspondingly formed thereto, will be described on the assumption that they are designed and manufactured in a rectangular shape.

More specifically, since the bonding medium frame body 280 is formed in a rectangular shape, portions corresponding to one end and the other end in a width direction are defined as a "first long side 280L-1" and a "second long side 280L-2," and portions corresponding to one end and the other end in a length direction are defined as a "first short side 280S-1" and a "second short side 280S-2."

In general, when heat generated from heat-generating elements of the electronic device (not shown) is received and exchanged with outside air (outdoor air), only a single heat dissipation apparatus 200 according to an embodiment of the present disclosure is not necessarily applied to a product (electronic device). Rather, the optimal number of heat dissipation apparatuses 200 may be determined according to the number and arrangement of the heat-generating elements, which are heat-generating devices.

In particular, although not shown in the drawings, when the heat-generating elements are arranged vertically with respect to a direction of gravity, the arrangement and coupling structure of the single heat dissipation apparatus 200 for effectively dissipating heat therefrom may also be variously determined according to an optimal design.

Further, as in the heat dissipation apparatus 200 according to an embodiment of the present disclosure, the refrigerant flow space 205 may also be partially divided into an evaporator and a condenser in consideration of gas-liquid circulation caused by the influence of gravity on refrigerants in respective phases that have undergone a phase change (evaporation) from a liquid refrigerant to a vapor refrigerant or a phase change (condensation) from a vapor refrigerant to a liquid refrigerant within the refrigerant flow space 205.

At this time, as shown in FIG. 4, the bonding medium frame body 280 may be entirely made of copper (Cu) regardless of the functional distinction between the above-described evaporator and condenser. Alternatively, a portion corresponding to the evaporator where higher thermal conductivity is required (e.g., the "first long side 280L-1" in FIG. 4) may be made of copper, while the remaining portion corresponding to the condenser (e.g., the "second long side 280L-2," the "first short side 280S-1," and the "second short side 280S-2" in FIG. 4) may be made of SUS, which is the material of the first-side heat-conducting panel 200A and second-side heat-conducting panel 200B.

However, the bonding medium frame body 280, separately manufactured as two portions of different materials, may be integrally formed by bonding boundary portions thereof to each other through butt welding. Alternatively, it may be stacked and bonded to corresponding portions of the first-side heat-conducting panel 200A and the second-side heat-conducting panel 200B without a separate bonding process.

Hereinafter, the first long side 280L-1 of the bonding medium frame body 280 and corresponding portions of the first-side heat-conducting panel 200A and second-side heat-conducting panel 200B will be defined as the evaporator, which is a portion that receives heat from the heat-generating elements, while the remaining portions will be defined as the condenser.

Meanwhile, as shown in FIGS. 3A to 3D, at least one of opposite ends of the plurality of condenser sintered columns 250 may be directly connected to the bonding medium frame body 280 without a separate coupling medium component such as the evaporator sintered base 255 to be described later.

Here, one end of the bonding medium frame body 280 and the plurality of condenser sintered columns 250 may be defined as an end on the side of the first long side 280L-1 corresponding to the above-described evaporator, which is a portion located substantially lower with respect to the direction of gravity.

Conversely, the other end of the bonding medium frame body 280 and the plurality of condenser sintered columns 250 may be defined as an end on the side of the second long side 280L-2 corresponding to the above-described condenser, which is a portion located substantially upper with respect to the direction of gravity.

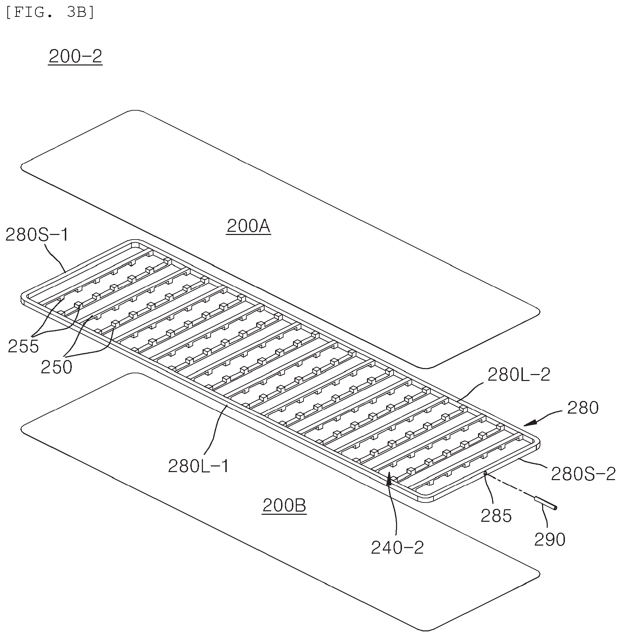

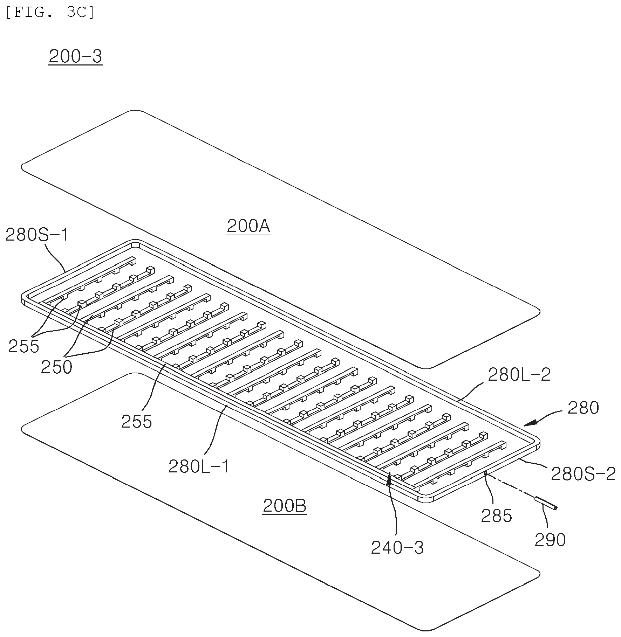

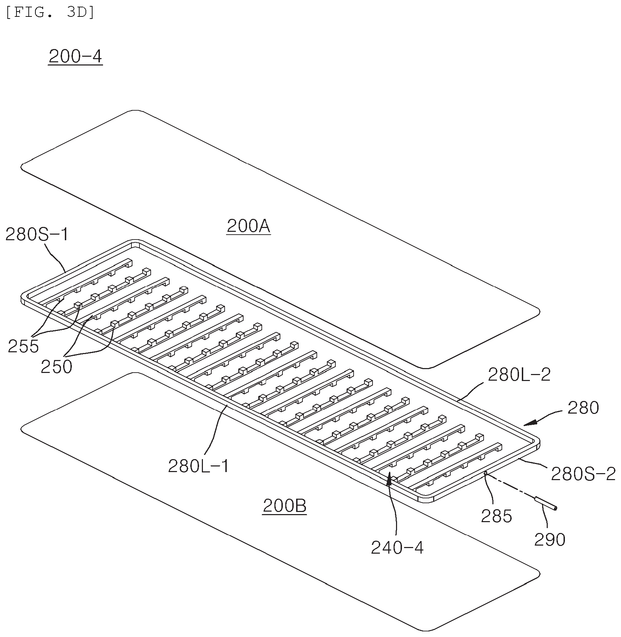

In the heat dissipation apparatus 200 according to an embodiment of the present disclosure, the plurality of condenser sintered columns 250 may be connected at one end thereof to the bonding medium frame body 280 via the evaporator sintered base 255 as shown in FIGS. 3A and 3C, and may be directly connected at one end thereof to the bonding medium frame body 280 as shown in FIGS. 3B and 3D.

Here, as already described, the plurality of condenser sintered columns 250 and the evaporator sintered base 255 may be formed by sintering powder of SUS.

In this way, the plurality of condenser sintered columns 250 and the evaporator sintered base 255 formed by sintering predetermined metal powder may perform a function of absorbing and distributing the liquid refrigerant through surface tension or capillary force via a plurality of pores that are naturally formed during the sintering process.

Here, when the vapor refrigerant is condensed through heat exchange with outside air (outdoor air) at a portion corresponding to the condenser and undergoes a phase change into the liquid refrigerant, the plurality of condenser sintered columns 250 may guide the flow of the liquid refrigerant such that, when the condensed liquid refrigerant flows downward in the direction of gravity toward the evaporator, the liquid refrigerant is evenly distributed without being biased.

In addition, the evaporator sintered base 255 may serve to actively induce the phase change (evaporation) of the liquid refrigerant, which is absorbed through the plurality of pores formed therein, into the vapor refrigerant by heat supplied from the heat-generating elements.

Further, the bonding medium frame body 280 may be formed with an air vent hole 285 to which an air vent tube 290 is connected.

The air vent hole 285 may be formed to communicate with the refrigerant flow space 205 whose boundary is defined by the first-side heat-conducting panel 200A, the second-side heat-conducting panel 200B, and the bonding medium frame body 280.

Meanwhile, the first-side heat-conducting panel 200A, the second-side heat-conducting panel 200B, and the bonding medium frame body 280 may be stacked and bonded by a welding method. Here, the welding method may include laser welding in addition to general welding.

However, the coupling method of the first-side heat-conducting panel 200A, the second-side heat-conducting panel 200B, and the bonding medium frame body 280 is not limited to the above-described welding method, and a stacked bonding method using brazing is not excluded.

The heat dissipation apparatus 200 according to an embodiment of the present disclosure configured as described above may be implemented in various modifications depending on whether the evaporator sintered base 255 is provided and the connection method of the condenser sintered columns 250 to the bonding medium frame body 280, as shown in FIGS. 3A to 3D.

That is, as shown in FIGS. 3A and 3C, the heat dissipation apparatus 200 according to an embodiment of the present disclosure may include a first implementation 200-1 and a third implementation 200-3, each implemented in a form including the evaporator sintered base 255, which connects respective lower ends of the plurality of condenser sintered columns 250 located at a lower side with respect to the direction of gravity and is connected to an inner end of the bonding medium frame body 280 located at an end corresponding to the lower side with respect to the direction of gravity among the edge portions of the first-side heat-conducting panel 200A and the second-side heat-conducting panel 200B.

Conversely, as shown in FIGS. 3B and 3D, the heat dissipation apparatus 200 according to an embodiment of the present disclosure may include a second implementation 200-2 and a fourth implementation 200-4, each implemented in a form in which the respective lower ends of the plurality of condenser sintered columns 250 are directly connected to the inner end of the bonding medium frame body 280 located at an end corresponding to the lower side with respect to the direction of gravity among the edge portions of the first-side heat-conducting panel 200A and the second-side heat-conducting panel 200B without interposing the evaporator sintered base 255.

Further, as shown in FIGS. 3A and 3B, the heat dissipation apparatus 200 according to an embodiment of the present disclosure may include the first implementation 200-1 and the second implementation 200-2, each implemented in a form in which the respective upper ends of the plurality of condenser sintered columns 250 are directly connected to ends located at the upper side with respect to the direction of gravity among the edge portions of the first-side heat-conducting panel 200A and the second-side heat-conducting panel 200B.

Conversely, as shown in FIGS. 3C and 3D, the heat dissipation apparatus 200 according to an embodiment of the present disclosure may include a third implementation 200-3 and a fourth implementation 200-4, each implemented in a form in which the respective upper ends of the plurality of condenser sintered columns 250 are spaced apart without being connected to ends located at the upper side with respect to the direction of gravity among the edge portions of the first-side heat-conducting panel 200A and the second-side heat-conducting panel 200B.

Meanwhile, in the heat dissipation apparatus 200 according to an embodiment of the present disclosure, each condenser sintered column 250 in all implementations 200-1 to 200-4 may be integrally formed with a plurality of support protrusions 251 which protrude to be supported on an inner surface of the first-side heat-conducting panel 200A and an inner surface of the second-side heat-conducting panel 200B.

More specifically, the condenser sintered column 250 may be sintered and formed in the shape of a quadrangular bar having four surfaces. One surface (hereinafter referred to as a "first surface") may be supported or fixed so as to be in surface contact with the inner surface of one (hereinafter assumed as the first-side heat-conducting panel 200A) of the first-side heat-conducting panel 200A and the second-side heat-conducting panel 200B, and front end surfaces of the plurality of support protrusions 251 may be formed on a surface (hereinafter referred to as a "second surface") facing the first surface of the condenser sintered column 250 so as to be supported or fixed in surface contact with the inner surface of the second-side heat-conducting panel 200B.

Such a condenser sintered column 250 is configured such that the first surface thereof is supported on the inner surface of the first-side heat-conducting panel 200A, and the front end surfaces of the plurality of support protrusions 251 formed on the second surface thereof are supported on the inner surface of the second-side heat-conducting panel 200B. This reinforces the rigidity of the first-side heat-conducting panel 200A and the second-side heat-conducting panel 200B, which are formed with a relatively thin thickness (0.15T), and prevents the movement of the first-side heat-conducting panel 200A and the second-side heat-conducting panel 200B, which may be shaken or displaced due to changes in internal pressure of the refrigerant flow space 205 during the phase change of the refrigerant. Therefore, energy involved in the phase change of the refrigerant is prevented from being converted into physical energy unrelated to heat dissipation, thereby improving heat dissipation performance.

Further, the vapor refrigerant or the liquid refrigerant may smoothly flow through the spaces between the plurality of support protrusions 251, thereby allowing vapor-liquid circulation to be evenly and uniformly distributed without being biased to one side.

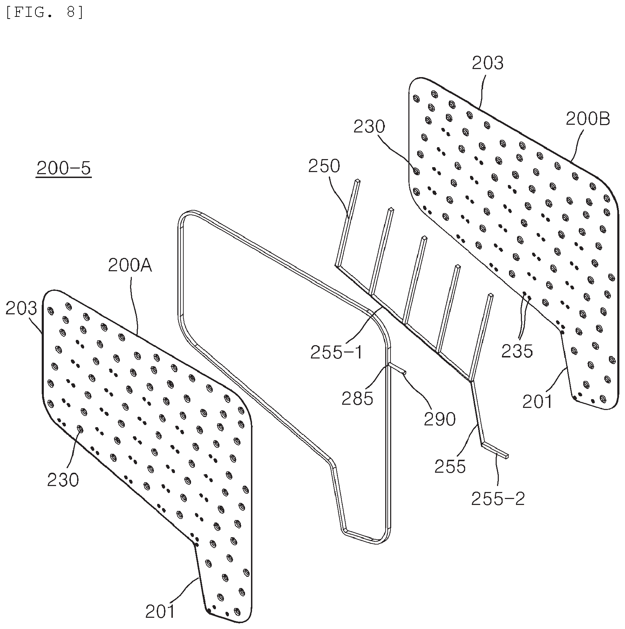

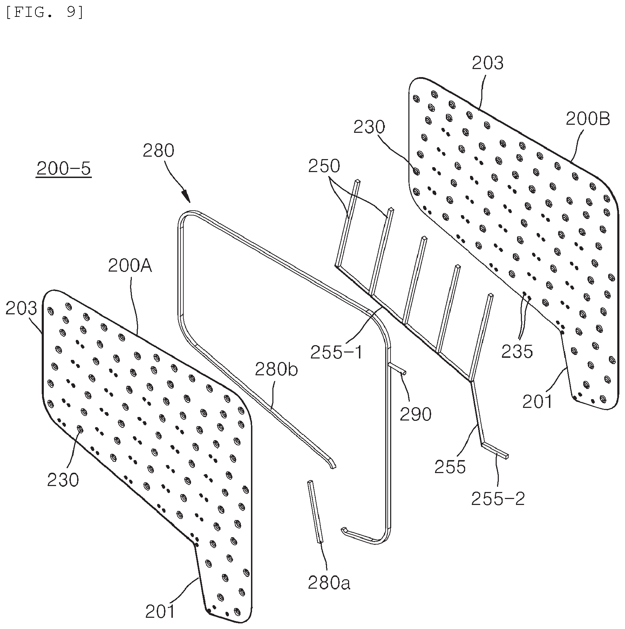

FIG. 7 is a perspective view illustrating a heat dissipation apparatus according to another embodiment of the present disclosure, FIG. 8 is an exploded perspective view of FIG. 7, and FIG. 9 is an exploded perspective view illustrating a modification of the heat dissipation apparatus according to another embodiment of the present disclosure.

A heat dissipation apparatus 200-5 according to another embodiment of the present disclosure, as shown in FIGS. 7 to 9, includes a first-side heat-conducting panel 200A provided as a metal panel member having a thermal conductivity equal to or greater than a predetermined level and formed by sheet metal processing through a press forming process, a second-side heat-conducting panel 200B provided as a metal panel member identical to first-side heat-conducting panel 200A and formed by sheet metal processing through a press forming process, the second-side heat-conducting panel forming, together with the first-side heat-conducting panel 200A, a refrigerant flow space 205 in which a refrigerant undergoes a phase change and flows, and a bonding medium frame body 280 disposed to mediate surface-bonded stacked coupling along edge portions of the first-side heat-conducting panel 200A and the second-side heat-conducting panel 200B.

Here, the heat dissipation apparatus 200-5 according to another embodiment of the present disclosure may include components that perform the same functions as those of heat dissipation apparatus 200 according to the embodiment of the present disclosure already described with reference to FIGS. 1 to 6, except for the configuration of a plurality of strength reinforcement portions 230 and column support protrusions 235 to be described later.

More specifically, in the heat dissipation apparatus 200-5 according to another embodiment of the present disclosure, the refrigerant flow space 205 in which a refrigerant undergoes a phase change and flows is also defined between the first-side heat-conducting panel 200A and the second-side heat-conducting panel 200B, and edge portions of the first-side heat-conducting panel 200A and the second-side heat-conducting panel 200B may be bonded so as to be stacked with each other by the bonding medium frame body 280, thereby sealing the refrigerant flow space 205.

In addition, an air vent tube 290 may be further installed in the bonding medium frame body 280 to vacuumize the refrigerant flow space 205 or to fill refrigerant.

Therefore, in the following description of the heat dissipation apparatus 200-5 according to another embodiment of the present disclosure, detailed description will be made mainly focusing on portions that differ from the heat dissipation apparatus 200 according to the embodiment of the present disclosure described above.

As shown in FIGS. 7 to 9, the heat dissipation apparatus 200-5 according to another embodiment of the present disclosure may include the plurality of strength reinforcement portions 230, which are formed by sheet metal processing during a press forming process so as to be recessed toward the refrigerant flow space 205 in the first-side heat-conducting panel 200A and the second-side heat-conducting panel 200B, and the column support protrusions 235 configured to support installation of the condenser sintered columns 250.

Here, the column support protrusions 235 may be designed to be spaced apart from each other by approximately the width of a pair of condenser sintered columns 250. When the first-side heat-conducting panel 200A and the second-side heat-conducting panel 200B are bonded to each other, the column support protrusions simultaneously support both ends of the condenser sintered column 250 in the width direction from both inner sides of the refrigerant flow space 205, thereby stably supporting the condenser sintered column 250, which is a relatively fragile sintered body.

Meanwhile, the plurality of strength reinforcement portions 230 not only perform a function of reinforcing the strength of the first-side heat-conducting panel 200A and the second-side heat-conducting panel 200B formed with a very thin thickness, but also may perform a function of actively responding to changes in internal pressure occurring during phase change of the refrigerant by bonding portions that contact each other within the refrigerant flow space 205 through a welding method.

Here again, the bonding medium frame body 280 is formed to correspond to outer shapes of the first-side heat-conducting panel 200A and the second-side heat-conducting panel 200B, and when the plurality of condenser sintered columns 250 are arranged vertically with respect to the direction of gravity, the evaporator sintered base 255 may be naturally disposed at a relatively lower position with respect to the direction of gravity.

However, the implementations 200-1 to 200-4 of the heat dissipation apparatus 200 according to the embodiment of the present disclosure described above are formed in the rectangular shape and the first long side 280L-1 corresponding to the long side serves as the evaporator connected close to heat-generating elements. Conversely, the heat dissipation apparatus 200-5 according to another embodiment of the present disclosure is designed such that only a part of the edge portion corresponding to a portion connected close to heat-generating elements (not shown), from which heat is substantially supplied, functions as the evaporator 201, while the remaining portions function as the condenser 203.

More specifically, in the heat dissipation apparatus 200-5 according to another embodiment of the present disclosure, when a portion below a dotted line indicated by reference numeral 205C in FIG. 7 is generally regarded as corresponding to the evaporator 201 in which the refrigerant is stored substantially in a liquid refrigerant form, portions excluding the evaporator 201 may function as the condenser 203, which is a region where vapor refrigerant is dispersed and flows or where condensed liquid refrigerant flows downward in the direction of gravity.

Here, the evaporator sintered base 255 is preferably formed only on the evaporator 201. However, in the heat dissipation apparatus 200-5 according to another embodiment of the present disclosure, a sintered first additional base 255-1 extending further toward an end side of the condenser 203 corresponding to an upper side of the evaporator 201, which is an end of the condenser 203 relatively located on a lower side with respect to the direction of gravity, and a sintered second additional base 255-2 extending further toward an end side of the condenser 203 corresponding to a lower side of the evaporator 201 may be further provided.

Since the sintered first additional base 255-1 is located relatively above the evaporator 201, it may serve to smoothly supply the liquid refrigerant, whose flow is guided in the direction of gravity through the plurality of condenser sintered columns 250, to the evaporator sintered base 255 on the evaporator 201.

In contrast, since the sintered second additional base 255-2 is formed to extend so as to contact the evaporator sintered base 255 that performs an original function, it may serve to indirectly expand the area of the evaporator 201, whose heat transfer area receiving heat generated from the heat-generating elements is relatively narrow.

As described above, the heat dissipation apparatuses 200 and 200-5 according to embodiments of the present disclosure are manufactured such that the first-side heat-conducting panel 200A and the second-side heat-conducting panel 200B, which are two metal base panels made of stainless steel (SUS) having relatively lower thermal conductivity but lower cost compared to aluminum (Al) among metal materials, are bonded to each other, and the flow of a refrigerant through the phase change of the refrigerant within the refrigerant flow space 205 defined therebetween is enabled, thereby significantly improving productivity of a product.

Further, since the thicknesses of the first-side heat-conducting panel 200A and the second-side heat-conducting panel 200B may be minimized, heat generated from the heat-generating elements may be rapidly received and active vapor-liquid circulation may be promoted through heat exchange with outside air, thereby significantly improving heat dissipation performance.

In addition, in the heat dissipation apparatuses 200 and 200-5 according to embodiments of the present disclosure, sharp metal portions generated along edges during press forming of the first-side heat-conducting panel 200A and the second-side heat-conducting panel 200B, which are made of the metal material, may be shaped to be rounded by the bonding medium frame body 280, thereby preventing injury to a worker.

As described above, a heat dissipation apparatus according to embodiments of the present disclosure has been described in detail with reference to the accompanying drawings. However, embodiments of the present disclosure are not necessarily limited to the above-described embodiment, and it will be apparent that various modifications and equivalent implementations are possible by those skilled in the art. Therefore, the true scope of the present disclosure is defined by the claims set forth below.

### [Industrial Applicability]

The present disclosure provides a heat dissipation apparatus in which heat dissipation performance can be maximized and productivity can be improved.

## Claims

1. A heat dissipation apparatus comprising:
a first-side heat-conducting panel provided as a metal panel member;
a second-side heat-conducting panel provided as a metal panel member and forming, together with the first-side heat-conducting panel, a refrigerant flow space in which a refrigerant undergoes a phase change and flows; and
a bonding medium frame body provided to mediate bonding of edge portions of the first-side heat-conducting panel and the second-side heat-conducting panel.

2. The heat dissipation apparatus of claim 1, wherein the bonding medium frame body seals the refrigerant flow space defined between the first-side heat-conducting panel and the second-side heat-conducting panel.

3. The heat dissipation apparatus of claim 1, wherein the first-side heat-conducting panel and the second-side heat-conducting panel are made of the same metal material having a thermal conductivity equal to or greater than a predetermined level.

4. The heat dissipation apparatus of claim 1, wherein the bonding medium frame body mediates surface-bonded stacked coupling along the edge portions of the first-side heat-conducting panel and the second-side heat-conducting panel.

5. The heat dissipation apparatus of claim 1, wherein the bonding medium frame body is disposed between the first-side heat-conducting panel and the second-side heat-conducting panel to provide a predetermined bonding surface with respect to an inner surface of the edge portion of the first-side heat-conducting panel and an inner surface of the edge portion of the second-side heat-conducting panel.

6. The heat dissipation apparatus of claim 1, wherein the bonding medium frame body has a rectangular pipe cross-section made of copper (Cu).

7. The heat dissipation apparatus of claim 6,
wherein a first surface of the rectangular pipe cross-section of the bonding medium frame body is surface-bonded to the inner surface of the edge portion of the first-side heat-conducting panel, and
wherein a second surface of the rectangular pipe cross-section of the bonding medium frame body, which faces the first surface, is surface-bonded to the inner surface of the edge portion of the second-side heat-conducting panel.

8. The heat dissipation apparatus of claim 1,
wherein, when a portion of the refrigerant flow space which is relatively located on a lower side with respect to a direction of gravity, in which liquid refrigerant of the refrigerant is stored and which is relatively close to heat-generating elements supplying heat, is defined as an evaporator,
the bonding medium frame body comprises a first frame installed close to the evaporator and a second frame installed at a portion other than the evaporator, the first frame and the second frame being made of different materials.

9. The heat dissipation apparatus of claim 8,
wherein the first frame is formed to have a rectangular pipe cross-section made of copper (Cu), and
wherein the second frame is formed to have a rectangular pipe cross-section made of SUS.

10. The heat dissipation apparatus of claim 1, further comprising:
a plurality of condenser sintered columns disposed in the refrigerant flow space and connected to the bonding medium frame body.

11. The heat dissipation apparatus of claim 10, wherein the plurality of condenser sintered columns are connected to the bonding medium frame body via an evaporator sintered base that connects respective one ends thereof.

12. The heat dissipation apparatus of claim 11, wherein the plurality of condenser sintered columns are provided in a straight line, and a lower end corresponding to the one end is positioned relatively lower than an upper end with respect to the direction of gravity.

13. The heat dissipation apparatus of claim 10, wherein one end of each of the plurality of condenser sintered columns is connected to an inner side of the bonding medium frame body that is relatively positioned on a lower side with respect to the direction of gravity.

14. The heat dissipation apparatus of claim 13, wherein the other end of each of the plurality of condenser sintered columns is connected to an inner side of the bonding medium frame body that is relatively positioned on an upper side with respect to the direction of gravity.

15. The heat dissipation apparatus of claim 13, wherein the other end of each of the plurality of condenser sintered columns is spaced apart from the bonding medium frame body that is relatively positioned on the upper side with respect to the direction of gravity, by a predetermined distance.

16. The heat dissipation apparatus of claim 3, wherein the first-side heat-conducting panel and the second-side heat-conducting panel are provided as metal panel members made of SUS.

17. The heat dissipation apparatus of claim 10, wherein the plurality of condenser sintered columns and the evaporator sintered base are formed by sintering powder of SUS.

18. The heat dissipation apparatus of claim 1, wherein the bonding medium frame body is formed with an air vent hole to which an air vent tube for vacuumizing the refrigerant flow space or filling the refrigerant is connected.

19. The heat dissipation apparatus of claim 18, wherein the air vent hole is formed to communicate with the refrigerant flow space.

20. The heat dissipation apparatus of claim 1, wherein the first-side heat-conducting panel, the second-side heat-conducting panel, and the bonding medium frame body are stacked and bonded by a laser welding method.

21. The heat dissipation apparatus of claim 1, wherein the first-side heat-conducting panel, the second-side heat-conducting panel, and the bonding medium frame body are stacked and bonded by a brazing welding method.

22. The heat dissipation apparatus of claim 10, wherein each of the plurality of condenser sintered columns is formed with a plurality of support protrusions that protrude toward and are supported by an inner surface of the first-side heat-conducting panel or the second-side heat-conducting panel within the refrigerant flow space.

23. The heat dissipation apparatus of claim 22, wherein the plurality of support protrusions comprise front end surfaces that contact the inner surface of the first-side heat-conducting panel or the second-side heat-conducting panel.
